# FASCICULE DE BREVET EUROPEEN

(11) **EP 2 752 868 B1**
(45) Date de publication et mention de la délivrance du brevet: **09.03.2016**
(21) Numéro de dépôt: 13199194.5
(22) Date de dépôt: 20.12.2013
(51) Int. Cl.: H01L 21/027, H01L 21/311, H01L 21/3115, H01L 21/3213

(54) **Procédé de réalisation de motifs dans une couche mince anti-réfléchissante**
Verfahren zur Erzeugung von Motiven in einer Antireflex-Dünnschicht
Method for producing patterns in an anti-reflective thin layer

(30) Priorité: 28.12.2012 FR 1262957
(43) Date de publication de la demande: 09.07.2014
(73) Titulaire: COMMISSARIAT A L'ENERGIE ATOMIQUE ET AUX ENERGIES ALTERNATIVES, 75015 Paris (FR); Centre National de la Recherche Scientifique, 75016 Paris (FR); Université Joseph Fourier - Grenoble, 38041 Grenoble Cedex 9 (FR)
(72) Inventeur: Posseme, Nicolas, 38000 Grenoble (FR); Joubert, Olivier, 38240 Meylan (FR); Vallier, Laurent, 38240 Meylan (FR)
(74) Mandataire: Hautier, Nicolas

(56) Documents cités:
- JP-A- H07 161 689
- US-A- 6 030 898

## Description

### DOMAINE TECHNIQUE

L'invention se rapporte au domaine des procédés de réalisation en couches minces par exemple de dispositifs microélectroniques ou de microsystèmes et plus particulièrement à celui de la formation de motifs dans une couche mince.

Elle concerne un procédé amélioré de réalisation de motifs dans une couche mince, en particulier de type SiARC, c'est à dire anti-réfléchissante et à base de silicium.

### ETAT DE LA TECHNIQUE ANTERIEURE

La réalisation d'un ou plusieurs motifs dans une couche mince est couramment effectuée à l'aide d'un procédé de photolithographie au cours duquel on forme un masquage de résine ayant un motif que l'on souhaite reporter dans la couche mince. Le report est ensuite réalisé par gravure de la couche mince à travers le masquage de résine.

On peut alors vouloir reporter à nouveau le motif réalisé dans une couche sous-jacente sur laquelle ladite couche mince repose.

Ce peut être le cas, par exemple, lorsque la couche mince est une couche anti-réfléchissante à base de silicium, en particulier de type SiARC, et repose sur une couche sous-jacente dans laquelle on souhaite réaliser un motif par exemple une couche à base de SiON ou de SiO₂ ou de TiN.

Pour cela, on peut vouloir utiliser à nouveau le masquage de résine comme masque de gravure.

Cependant, lors de la réalisation du motif dans la couche mince, le masquage de résine peut avoir tendance à se consommer.

Cela pose d'autant plus problème lorsque le masquage de résine a initialement une faible dimension critique. Cette consommation intempestive du masquage de résine peut empêcher une réalisation d'un motif précis dans la couche sous-jacente ou empêcher le report intégral du motif dans la couche sous-jacente lorsque l'épaisseur de cette couche sous-jacente est trop importante.

Dans le cas où la couche mince dans laquelle on souhaite réaliser un motif est une couche anti-réfléchissante contenant du silicium de type SiARC, pour pallier à ce problème, il est connu de prévoir cette couche avec une concentration en Si accrue de manière à améliorer la sélectivité de gravure entre le matériau de cette couche mince et le masquage de résine.

Une autre solution connue prévoit la réalisation d'une gravure anisotrope dans un réacteur contenant des produits fluorocarbonés ou à base de CₓH_{y}.

Cependant, une telle méthode ne permet d'obtenir qu'une sélectivité limitée à 2.

JP H07 161689 A divulgue un procédé de réalisation d'un motif dans une première couche.

Il se pose le problème de trouver un nouveau procédé de réalisation de motifs dans une couche mince qui ne présente pas les inconvénients évoqués ci-dessus.

### EXPOSÉ DE L'INVENTION

Selon un mode de réalisation, la présente invention concerne un procédé de réalisation d'un motif dans une première couche formant de préférence une couche mince, comprenant les étapes de :
- formation sur une première couche d'au moins un bloc de masquage à base par exemple de résine photosensible reposant sur ladite première couche,
- implantation de zones de la première couche situées en périphérie dudit bloc de masquage, à l'aide d'au moins une espèce dopante, l'espèce dopante étant choisie de sorte que les zones dopées sont susceptibles d'être gravées sélectivement vis-à-vis du reste de la première couche et vis-à-vis du bloc de masquage,
- gravure sélective des zones dopées de ladite première couche. Cette gravure consomme les zones dopées de ladite première couche sélectivement aux zones non dopées de la première couche et au bloc de masquage.

Avantageusement, l'implantation de l'espèce dopante dans le matériau de la première couche augmente la vitesse de gravure de ce matériau dans les zones où il est dopé. Les zones implantées se consomment alors plus rapidement que les zones non implantées de la première couche. Les zones implantées se consomment également plus rapidement que le bloc de masquage.

L'implantation permet ainsi de graver la première couche en consommant moins de résine que les solutions connues, voire sans consommer de résine.

L'invention permet ainsi d'obtenir des motifs présentant un rapport de forme très élevé -le rapport de forme étant le rapport de la largeur ou du diamètre (pris dans le plan *i̅ j̅*) du motif sur sa hauteur (prise dans le plan *k̅ i̅*).

Avant l'implantation, on recouvre la première couche et ledit bloc de masquage d'une couche de protection. Avantageusement, la couche de protection protège la couche de résine lors de l'implantation, empêchant la consommation de résine lors de cette implantation.

Selon l'invention, l'implantation en particulier son énergie, la concentration des espèces dopantes ou la dose utilisée et la durée du procédé d'implantation sont prévues de sorte que lesdites zones dopées situées en périphérie dudit bloc de masquage et une région non implantée de ladite première couche située sous le bloc de masquage ont une frontière disposée à l'aplomb ou dans le prolongement de la ou des faces latérales dudit bloc de masquage.

L'invention permet ainsi de réaliser des motifs présentant un rapport de forme encore plus élevé sans risque de surgravure sous le bloc de masquage.

En outre, la couche de protection, en particulier sa composition et son épaisseur, est prévue de sorte que lesdites zones dopées situées en périphérie dudit bloc de masquage et une région non implantée de ladite première couche située sous le bloc de masquage ont une frontière disposée à l'aplomb ou dans le prolongement de la ou des faces latérales dudit bloc de masquage.

De manière facultative, l'invention présente au moins l'une quelconque des caractéristiques et étapes optionnelles énoncées ci-dessous :
Selon un mode de réalisation particulièrement avantageux, l'implantation est effectuée à l'aide d'un plasma.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention.

Selon un mode de réalisation particulièrement avantageux, l'implantation et la gravure de la couche implantée sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.

De préférence, la formation de la couche de protection, ladite implantation et ladite gravure sont réalisées dans un même réacteur plasma.

Ladite première couche peut être une couche à base de Si. Elle est par exemple destinée à former un masque dur à base de silicium.

Le procédé peut s'appliquer à une couche à base de silicium telle que, par exemple, une couche de SiO₂, ou de SiON, ou de SiOC.

Selon un mode de réalisation particulièrement avantageux, la première couche est une couche anti-réfléchissante SiARC.

De préférence, ledit bloc de masquage est disposé en contact avec la première couche. L'invention évite ainsi d'avoir à disposer une couche intermédiaire entre la couche à base de silicium ou en SiARC pour graver cette dernière.

Ladite couche de protection peut avoir une épaisseur faible et peut être comprise entre 1 nanomètre et 3 nanomètres.

Une épaisseur trop importante de la couche de protection empêche de placer la frontière entre zones dopée et zones non-dopées à l'aplomb ou dans le prolongement de la ou des faces latérales dudit bloc de masquage.

Ladite espèce dopante peut être à base d'hydrogène, ce qui permet de former des zones dopées comportant des liaisons Si-H dans le cas où la première couche contient du Si.

La gravure sélective peut être ainsi réalisée, par exemple, à l'aide d'un bain humide à base d'acide fluorhydrique (HF) dilué dans l'eau de-ionisée.

Le dopage peut être réalisé avec une énergie d'implantation faible en particulier comprise entre 100eV et 600eV.

Le procédé suivant l'invention permet de réaliser des motifs en utilisant un bloc de masquage présentant une dimension critique réduite, c'est-à-dire typiquement une largeur réduite par rapport aux solutions connues. En particulier, l'invention permet d'effectuer une opération d'amincissement du bloc de masquage (habituellement qualifiée en anglais de « trimming ») tout en autorisant une gravure de la première couche sur une profondeur importante. De manière connue, une opération de trimming vise à réduire la largeur du bloc de masquage après sa réalisation typiquement par photolithographie. Cette opération de trimming consomme les flancs du bloc et réduit donc la dimension critique de ce dernier. L'inconvénient habituellement induit par avec cette opération est que la hauteur du bloc est inévitablement consommée en même temps que les flancs. Il s'en suit que l'amincissement est nécessairement limité puisqu'une consommation excessive de la hauteur du bloc empêche par la suite de graver la couche sous jacente sur une épaisseur satisfaisante. En supprimant ou en réduisant la consommation de la résine lors de la gravure de la première couche, l'invention autorise ainsi un amincissement préalable du bloc de masquage au-delà de ce que permettent les solutions connues. L'invention permet ainsi d'obtenir dans la première couche des motifs présentant des dimensions critiques réduites.

Selon l'invention, le bloc de masquage forme un masque. La gravure est effectuée alors que le bloc de masquage est en place sur la première couche. Si le ou les blocs de masquage forment un masque, la gravure est ainsi effectuée à travers ledit masque.

Selon un mode de réalisation, l'implantation est réalisée de manière à ce que les zones dopées s'étendent sur une profondeur inférieure à l'épaisseur de la première couche.

De préférence, le procédé comprend une pluralité de cycles comprenant chacun une étape de formation de la couche de protection ; une étape d'implantation de l'au moins une espèce dopante et la gravure des zones dopées de la première couche sélectivement aux zones non dopées de la première couche et au bloc de masquage.

Selon un autre mode de réalisation, l'implantation est réalisée de manière à ce que les zones dopées s'étendent sur une profondeur supérieure ou égale à l'épaisseur de la première couche. La gravure consomme alors toute l'épaisseur de la première couche.

La première couche peut reposer sur une deuxième couche ou couche sous-jacente dans laquelle on souhaite reporter le motif réalisé dans la couche anti-réfléchissante. Ainsi, le procédé suivant l'invention peut comprendre en outre, après la gravure sélective de zones dopées de ladite première couche, la gravure de la deuxième couche en se servant de la couche anti-réfléchissante comme d'un masque dur.

### BRÈVE DESCRIPTION DES DESSINS

La présente invention sera mieux comprise à la lecture de la description d'exemples de réalisation donnés, en faisant référence aux dessins annexés sur lesquels :
- les figures 1A-1D illustrent un exemple de procédé suivant l'invention permettant de réaliser des motifs dans une couche mince, en particulier une couche anti-réfléchissante ;
- la figure 2 donne des exemples de courbes d'évolution C₁, C₂ d'épaisseur gravée de couches de SiARC dopée (courbe C₂) et non-dopée (courbe C₁) en fonction d'une durée de trempage dans une solution de gravure à base de HF ;
- les figures 3A-3C et 4 illustrent des variantes de réalisation d'un procédé suivant l'invention permettant de réaliser des motifs dans une couche mince ;
Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

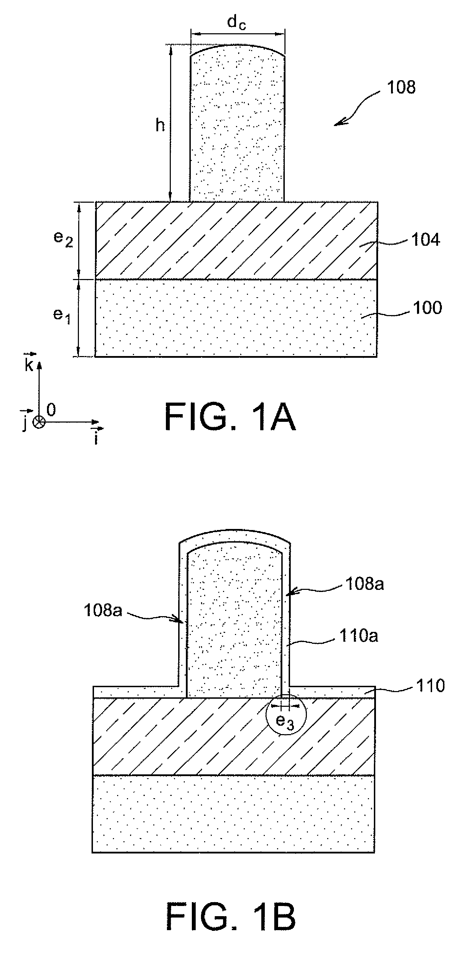

Un premier exemple de procédé, suivant l'invention, de réalisation d'un motif dans une couche mince, va à présent être décrit en liaison avec les figures 1A à 1D.

Le matériau de départ du procédé peut comprendre une couche mince 100 appelée couche sous-jacente recouverte d'une autre couche mince 104 dans laquelle on souhaite réaliser au moins un motif.

La couche sous-jacente 100 peut-être par exemple une couche de matériau diélectrique telle qu'une couche de SiO₂ ou de Si₃N₄, ou par exemple une couche métallique telle qu'une couche de TiN, ou par exemple une couche de carbone.

La couche sous-jacente 100 peut avoir une épaisseur e₁ (mesurée dans une direction parallèle au vecteur *̅k̅*̅ du repère orthogonal [O; *i̅ ; j̅ ; k̅*] représenté sur la figure 1A) comprise par exemple entre 10 nm nanomètres et 80 nm nanomètres.

L'autre couche 104 reposant sur la couche sous-jacente 100 et dans laquelle on souhaite réaliser un motif est une couche anti-réfléchissante qui peut être à base de silicium, et qui est communément notée SiARC (ARC pour « Anti Reflective Coating »). L'invention s'étend néanmoins à toutes les couches à base de silicium. Elle permet ainsi par exemple de définir les motifs d'un masque dur à base de silicium.

La couche anti-réfléchissante 104 peut par exemple, contenir une proportion de Si de l'ordre de 30%, une proportion d'Oxygène de l'ordre de 50%, une proportion de Carbone de l'ordre de 20%.

Cette couche anti-réfléchissante 104 peut avoir une épaisseur e₂, comprise par exemple entre 10 nm nanomètres et 80 nm nanomètres.

Sur la couche anti-réfléchissante 104 on forme tout d'abord un masquage sous forme d'au moins un bloc 108, à base de résine photo-sensible, ayant un motif que l'on souhaite reproduire dans la couche anti-réfléchissante 104.

Le bloc de masquage 108 à base de résine peut avoir une hauteur h (mesurée dans une direction parallèle au vecteur *̅k̅*̅ du repère orthogonal [O*; i̅ ; j̅ ; k̅*] représenté sur la figure 1A) comprise par exemple entre 30 nanomètres et 120 nanomètres et une dimension critique dc (définie comme la plus petite dimension d'un motif hormis son épaisseur ou sa hauteur et mesurée dans une direction parallèle au plan [O; *i̅ ; j̅*] du repère orthogonal [O; *i̅ ; j̅ ; k̅*]) comprise entre 10 nanomètres et plusieurs centaines de nanomètres, par exemple de 200 nm.

Par « dimension critique », on entend, tout au long de la présente description, la plus petite dimension d'un élément hormis son épaisseur.

On forme ensuite une fine couche de protection 110 sur la couche anti réfléchissante 104 et sur le bloc masquage 108 à base de résine photosensible. La couche de protection 110 est réalisée de manière à recouvrir les flancs latéraux 108a du bloc 108 de masquage et le dessus de ce bloc 108.

Cette couche de protection 110 peut-être une couche d'un type communément appelé « liner » à base d'un matériau diélectrique tel que du SiO₂, Si₃N₄, ou du SiOC.

L'épaisseur e₃ de la couche de protection 110, en particulier dans des zones 110a la couche recouvrant les flancs latéraux 108a du bloc de masquage 108 de résine est choisie faible, par exemple entre 1 nanomètres et 3 nanomètres.

Cette épaisseur e₃ est choisie en fonction d'une étape d'implantation de la couche anti-réflective 104 destinée à être réalisée ultérieurement (figure 1B).

La couche de protection 110 peut être réalisée dans un réacteur de gravure et en particulier dans le même réacteur que celui utilisé pour les autres étapes de ce procédé. Le réacteur peut être par exemple de type ICP (ICP pour « Inductively Coupled Plasma » ou CCP (CCP pour « Capacitive Coupled Plasma »), en utilisant une association chimique de type SiCl₄/O₂, ou de type SiF₄/O₂ pour déposer du SiO₂ ou de type SiF₄/N₂ ou SiCl₄/N₂ pour déposer du Si₃N₄.

Les conditions de dépôt peuvent être par exemple telles qu'un débit de SiCl₄ ou de SiF₄ compris entre 50 et 200 sccm, et un débit de N₂ ou de O₂ compris entre 10 et 50 sccm, sont mis en oeuvre

Selon un exemple détaillé de réalisation, pour former une couche de protection 110 à base de SiO₂, avec une épaisseur e₃ de l'ordre de 3 nm, un procédé utilisant un réacteur de type ICP avec une puissance de source comprise par exemple entre 50 W et 1000 W, ainsi qu'une puissance de polarisation comprise par exemple entre 0 W et 1000 W peuvent être mis en oeuvre avec du SiF₄ selon un débit de 50 sccm et du O₂ selon un débit de 25 sccm, selon une pression de l'ordre de 10 mTorr pendant une durée de 10 secondes.

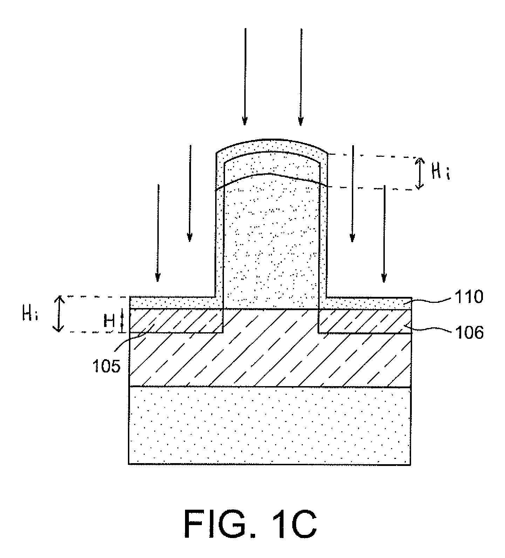

Ensuite (figure 1C), on effectue une implantation de zones 105, 106 de la couche anti-réfléchissante 104 qui ne sont pas surmontées par le bloc 108, mais situées en périphérie de ce bloc 108.

Cette implantation est réalisée de préférence sur l'ensemble de la surface de la plaque comprenant la couche anti-réfléchissante 104. Cette implantation est donc une implantation « pleine plaque ». Les blocs 108 de masquage empêchent l'implantation de l'espèce dopante dans les zones de la couche anti-réfléchissante 104 qui sont situées sous le bloc 108.

La couche de protection 110 est configurée pour empêcher la consommation de résine lors de l'implantation. L'espèce dopante peut néanmoins être implantée dans la résine à travers la couche de protection. Cette implantation dans la résine ne consomme toutefois pas cette dernière.

Lors de l'implantation, la couche SiARC n'est pas non plus consommée.

Cette implantation est réalisée à l'aide d'une espèce destinée à permettre de former des zones 105, 106 dopées susceptibles d'être gravées sélectivement vis-à-vis du reste de la couche anti-réfléchissante 104.

L'implantation peut être effectuée à l'aide de plasma, de préférence à base de H₂ lorsque la couche anti-réfléchissante 104 est à base de silicium. Des plasmas formés à partir d'autres espèces conviennent également.

Comme indiqué précédemment, une modification de la couche effectuée par une implantation à l'aide d'un plasma a pour avantage de permettre une implantation en continue depuis la surface libre de la couche 110 et sur une épaisseur faible, typiquement comprise entre 0 et 100 nm voire entre 0 et 30nm. Elle permet également de bénéficier d'une sélectivité améliorée dès le début de la gravure et d'une vitesse de gravure constante, conduisant à une précision de gravure améliorée. Elle permet également d'effectuer la modification et le retrait de la couche modifiée dans une même enceinte.

Dans le cas où la couche anti-réfléchissante 104 contient du Si, une implantation à base d'hydrogène peut permettre de former des liaisons Si-H, ayant une sensibité accrue au HF.

L'implantation de l'espèce dopante dans le bloc de masquage 108 ne modifie pas sa sensibilité à la gravure. De manière plus générale, cette implantation augmente moins fortement la sensibilité à la gravure du bloc de masquage 108 que la sensibilité à la gravure de la couche de SiARC 104 dans ses zones implantées 105, 106. Ainsi, seule les zones implantées 105, 106 de la couche de SiARC 104 présentent une sensibilité accrue à la gravure. L'implantation permet donc de rendre les zones implantées 105, 106 de la couche de SiARC 104 plus sensibles à la gravure que les zones non implantées de la couche de SiARC et que le bloc de masquage 108, dans ses zones implantées et non implantées.

L'implantation peut être avantageusement réalisée dans le même réacteur que celui dans lequel la couche de protection 110 a été formée.

Un plasma à base d'H₂, de HBr ou de He peut être utilisé selon une puissance bias qui peut être par exemple supérieure à 50 W et une puissance de source qui peut être comprise par exemple entre 0 W et 2000 W, selon une durée comprise entre plusieurs secondes et plusieurs minutes, par exemple de l'ordre de 3 à 4 minutes.

Pour réaliser une implantation d'ions hydrogène selon une profondeur notée Hi de l'ordre de 10 nm, à travers une couche de protection 110 à base de SiO₂ d'épaisseur qui peut être comprise entre 1 nm et 3 nm et une couche anti-réfléchissante 104 à base de Si, un procédé utilisant du H₂ avec un débit de 200 sccm, selon une puissance de source de 500 W, une puissance de bias 150 W, une pression de mTorr, une durée de 60 s peut être mis en oeuvre. Sur la figure 1C, Hi représente la profondeur totale d'implantation, tant dans la couche anti-réfléchissante 104 que dans la couche de résine du bloc de masquage 108.

L'énergie d'implantation peut être comprise par exemple entre 0.1 keV et 1 keV, par exemple inférieure à 500 eV. La profondeur H d'implantation dans la couche anti-réfléchissante peut être prévue inférieure à e₂ et comprise par exemple entre 5 nm et 30 nm.

L'épaisseur de la couche de protection 110, l'énergie d'implantation, la concentration des espèces dopantes ou dose d'implantation, et la durée d'implantation, sont choisies de sorte que, la frontière F entre les zones dopées 105, 106 de la couche anti-réfléchissante 104 situées autour du bloc de masquage 108 et une région 107 non-dopée de cette couche anti-réfléchissante 104 située sous le bloc de masquage 108, est située dans le prolongement des flancs latéraux 108a du bloc 108 de résine et alignée avec les flancs latéraux 108a du bloc de masquage 108.

La concentration des espèces, peut être comprise par exemple entre 50 sccm et 1000 sccm typiquement 200 sccm. La durée d'implantation peut être comprise par exemple entre 10 s et 180 s typiquement de l'ordre de 60s.

Une implantation sans couche de protection 110 conduirait à un déplacement de cette frontière sous le bloc de résine 108 ce qui entrainerait ultérieurement une surgravure et la réalisation réalisation d'un motif trop étroit dans la couche anti-réfléchissante 104.

Une implantation avec une couche de protection 110 d'épaisseur trop importante conduirait à un déplacement de cette frontière F au delà du bloc de résine 108. Cela entrainerait ultérieurement la réalisation d'un motif de largeur trop importante dans la couche anti-réfléchissante 104.

Ensuite, après l'implantation, la couche de protection 110 est retirée. Ce retrait peut être réalisé en même temps que celui de zones dopées de la couche anti-réfléchissante 104 permettant de reproduire le motif du bloc de masquage. On effectue une gravure des zones dopées 105, 106 de la couche anti réfléchissante 104 à travers le motif 108 par exemple par gravure humide dans une solution de HF. Un solution de HF à 1% peut être par exemple utilisée. Avantageusement, le dopage permet d'améliorer la sélectivité de la gravure de la couche de SiARC dans ses zones dopées, par rapport à la résine. Ainsi, la résine du bloc de masquage 108 n'est pas consommée, même dans sa partie implantée, alors que la couche anti-réfléchissante 104 est consommée sur toute son épaisseur H implantée.

Dans ce cas, la durée de la gravure est prévue suffisamment courte pour permettre de conserver une bonne sélectivité entre les zones 105, 106 de SiARC dopées et le reste de la couche de SiARC.

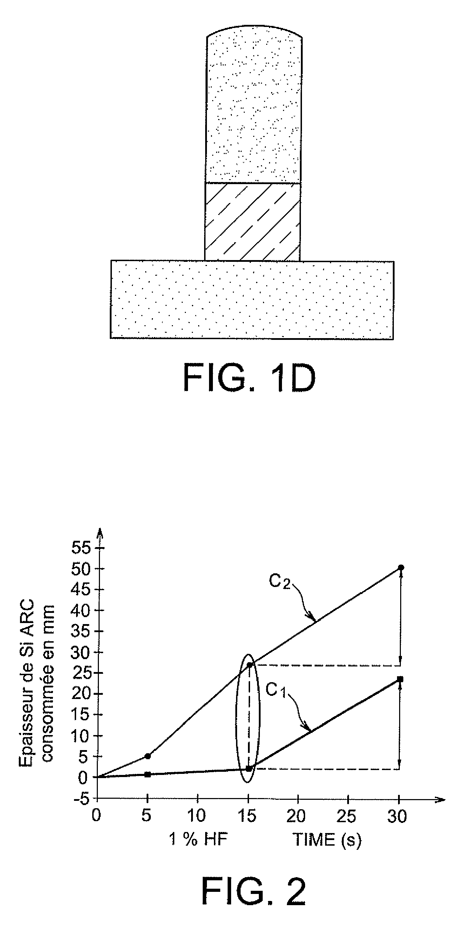

Les courbes C₁ et C₂ de la figure 2 représentent respectivement une épaisseur consommée de SiARC non dopé et une épaisseur consommée de SiARC dopé, en fonction d'une durée de trempage dans une solution de HF 1%. Ainsi, dans un cas, par exemple, où l'on souhaite graver une couche à base de SiARC à l'aide d'une solution de HF 1%, une durée de trempage comprise entre 5 s et 15 s peut être mise en oeuvre.

Un trempage dans une solution de HF 1% pendant une durée de l'ordre de 15 secondes peut, par exemple, permettre de retirer une épaisseur des zones dopées 105, 106, à base de SiARC de l'ordre de 27 nanomètres.

La gravure de la couche anti-réfléchissante 104 peut être réalisée en une seule fois, notamment dans un cas où elle a une épaisseur e₂ inférieure à 30 nanomètres.

De manière générale, lorsque les zones implantées 105 et 106 ont une épaisseur ou une profondeur supérieure ou égale à l'épaisseur totale e₂ de la couche anti-réfléchissante 104, alors toute l'épaisseur de la couche anti-réfléchissante 104 peut être gravée en une seule gravure (figure 1D).

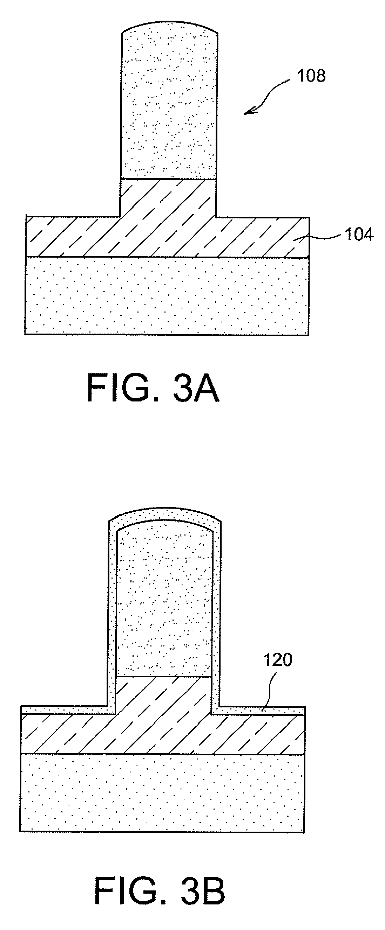

A l'inverse, lorsque les zones implantées 105, et 106 ont une épaisseur ou une profondeur inférieure à l'épaisseur totale e₂ de la couche anti-réfléchissante 104, de préférence seule une portion de l'épaisseur de la couche anti-réfléchissante 104 est gravée en une seule gravure (figure 3A). A l'issue de cette première gravure, le motif que l'on souhaite réaliser dans la couche anti-réfléchissante 104 est partiellement réalisé et une épaisseur restante à graver de la couche anti réfléchissante 104 subsiste.

On peut ensuite terminer la réalisation du motif par gravure de la couche anti-réfléchissante 104 à l'aide d'une chimie traditionnelle telle que du CF₄/N₂ ou HBr/O₂.

Pour achever la réalisation du motif dans la couche anti-réfléchissante 104, on peut, en variante, réitérer des étapes de procédé telles que décrites en liaison avec les figures 1B et 1C.

On dépose ensuite une autre couche de protection 120 du type de la couche de protection 110 sur la couche anti-réfléchissante 104 et le motif de résine 108 (figure 3B) dont l'épaisseur est choisie en fonction d'une étape d'implantation destinée à être réalisée ultérieurement.

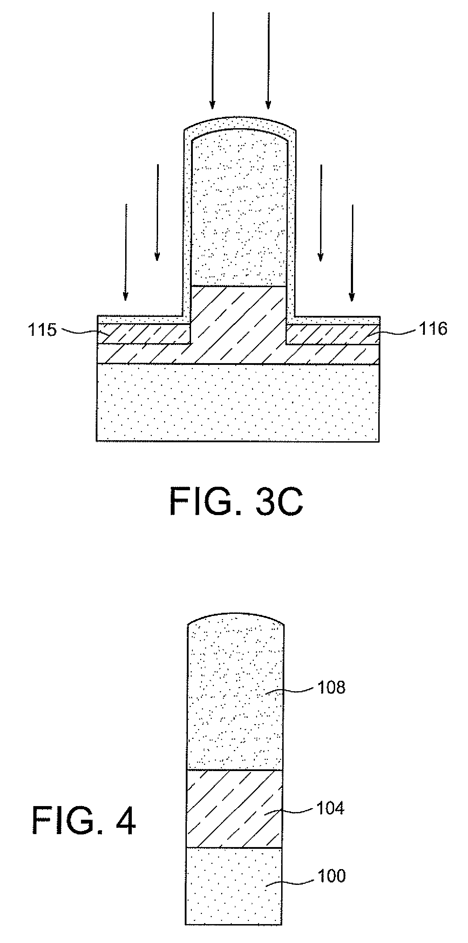

On effectue ensuite un dopage par implantation de zones 115, 116 de la couche anti-réfléchissante 104 à travers la couche de protection 120 (figure 3C).

On retire ensuite la couche de protection 120 et l'on effectue une gravure des zones implantées 115, et 116, de manière à poursuivre la formation d'un motif dans la couche 104.

Cette gravure sélective peut-être par exemple réalisée à l'aide de HF lorsque les zones implantées 115, et 116 sont des zones à base de silicium et ont été dopées à l'aide d'hydrogène.

Après une ou plusieurs répétitions de la séquence de procédé décrite en liaison avec les figures 1B-1C-3A, on obtient un motif dans la couche sacrificielle 104 comme sur la figure 1D, reproduisant celui du bloc 108 de masquage.

On peut ensuite reporter le motif réalisé dans la couche anti-réfléchissante 104 dans la souche sous-jacente 100, par gravure anisotrope en se servant de la couche anti-réfléchissante 104 comme d'un masque dur (figure 4).

## Revendications

1. Procédé de réalisation d'un motif dans une première couche (104) comprenant les étapes de :
- formation, sur une première couche (104), en particulier anti-réfléchissante, recouverte d'au moins un bloc (108) de masquage à base de résine photosensible reposant sur ladite première couche, d'une couche de protection (110, 120) recouvrant la première couche (104) et ledit bloc (108) de masquage,
- implantation de zones (105, 106, 115, 116) de la première couche (104) situées en périphérie dudit bloc (108) de masquage, à l'aide d'au moins une espèce dopante, l'espèce dopante étant choisie de sorte que les zones dopées (105, 106, 115, 116) sont susceptibles d'être gravées sélectivement vis-à-vis du reste de la première couche (104) et vis-à-vis du bloc (108) de masquage, l'implantation en particulier son énergie sa durée et la dose d'implantation, ainsi que la couche de protection (110, 120) , en particulier son épaisseur, étant prévues de sorte que lesdites zones (105, 106, 115, 116) dopées situées en périphérie dudit bloc de masquage et une région non implantée de la première couche (104) située sous le bloc (108) de masquage ont une frontière disposée à l'aplomb ou dans le prolongement de la ou des faces latérales dudit bloc de masquage,
- gravure des zones dopées (105, 106, 115, 116) de la première couche (104) sélectivement aux zones non dopées de la première couche (104) et au bloc (108) de masquage.

2. Procédé de réalisation selon la revendication 1, ladite première couche (104) étant une couche à base de Si.

3. Procédé de réalisation selon l'une des revendications 1 ou 2, ladite première couche (104) étant une couche anti-réfléchissante SiARC.

4. Procédé de réalisation selon l'une quelconque des revendications précédentes, ladite implantation étant effectuée à l'aide d'un plasma.

5. Procédé de réalisation selon l'une quelconque des revendications précédentes, ladite espèce dopante étant à base d'hydrogène.

6. Procédé de réalisation selon l'une quelconque des revendications précédentes, l'implantation étant réalisée avec une énergie d'implantation comprise entre 100 eV et 600 eV.

7. Procédé de réalisation selon l'une quelconque des revendications précédentes, ladite couche de protection ayant une épaisseur comprise entre 1 nanomètre et 3 nanomètres.

8. Procédé de réalisation selon l'une quelconque des revendications précédentes, ledit bloc de masquage ayant une dimension critique (dc) comprise entre 10 nm et 200 nm.

9. Procédé de réalisation selon l'une quelconque des revendications précédentes, ladite gravure sélective étant réalisée à l'aide de HF.

10. Procédé de réalisation selon l'une quelconque des revendications précédentes, ledit bloc (108) de masquage étant disposé en contact avec la première couche (104).

11. Procédé de réalisation selon l'une quelconque des revendications précédentes, dans lequel l'implantation est réalisée de manière à ce que les zones dopées (105, 106, 115, 116) s'étendent sur une profondeur inférieure à l'épaisseur de la première couche (104).

12. Procédé de réalisation selon l'une quelconque des revendications précédentes, comprenant une pluralité de cycles comprenant chacun ladite étape de formation de la couche de protection (110, 120), ladite étape d'implantation et ladite étape de gravure des zones dopées (105, 106, 115, 116) de la première couche (104) sélectivement aux zones non dopées de la première couche (104) et au bloc (108) de masquage.

13. Procédé de réalisation selon l'une des revendication 1 à 10, dans lequel ladite implantation est réalisée de manière à ce que les zones dopées (105, 106, 115, 116) s'étendent sur une profondeur supérieure ou égale à l'épaisseur de la première couche (104), et dans lequel ladite gravure consomme toute l'épaisseur de la première couche (104).

14. Procédé de réalisation selon l'une quelconque des revendications précédentes, dans lequel la première couche (104) repose sur une deuxième couche (100), le procédé comprenant en outre, après ladite gravure sélective de zones dopées (105, 106, 115, 116) de la première couche (104), une gravure de la deuxième couche à travers la première couche (104).

15. Procédé de réalisation selon l'une quelconque des revendications précédentes, dans lequel ladite implantation est effectuée à l'aide d'un plasma, et dans lequel la formation de la couche de protection (110, 120) , ladite implantation et ladite gravure sont réalisées dans un même réacteur plasma.

## Patentansprüche

1. Verfahren zur Erzeugung eines Musters auf einer ersten Schicht (104), welches die Schritte umfasst:
- Bilden einer Schutzschicht (110, 120) auf einer ersten Schicht (104), insbesondere einer nicht-reflektierenden, die mindestens von einem auf der ersten Schicht angeordneten Masken-Block (108) aus photosensitivem Harz bedeckt ist, welche die erste Schicht (104) und den Masken-Block (108) bedeckt,
- Erzeugen von Bereichen (105, 106, 115, 116) in der ersten Schicht (104) um den Maskenblock (108) mit mindestens einem Dotierungsmittel, wobei das Dotierungsmittel derart ausgewählt ist, dass die dotierten Bereiche (105, 106, 115, 116) im Vergleich zum Rest der ersten Schicht (104) und dem Maskenblock (108) für eine selektive Prägung empfindlich sind, wobei beim Erzeugen, insbesondere die Energiedauer und die Dosis sowie die Schutzschicht (110, 120), insbesondere deren Dicke derart vorgesehen ist, dass die dotierten Bereiche (105, 106, 115, 116) um den Maskenblocks (108) und ein nicht dotierter Bereich der ersten Schicht (104) unter dem Maskenblock (108) eine Grenze aufweisen, die im Lot zu oder in Verlängerung zu dem Maskenblock (108) oder dessen Seitenflächen angeordnet sind;
- Prägen der dotierten Bereiche (105, 106, 115, 116) der ersten Schicht (104) selektiv in nicht dotierten Bereichen der ersten Schicht (104) und am Maskenblock (108).

2. Erzeugungsverfahren nach Anspruch 1, wobei die erste Schicht (104) eine Schicht aus Si ist.

3. Erzeugungsverfahren nach einem der Ansprüche 1 oder 2, wobei die erste Schicht (104) eine nicht-reflektierende SiARC-Schicht ist.

4. Erzeugungsverfahren nach einem der vorstehenden Ansprüche, wobei die Durchführung mittels eines Plasmas erfolgt.

5. Erzeugungsverfahren nach einem der vorstehenden Ansprüche, wobei das Dotierungsmittel aus Wasserstoff besteht.

6. Erzeugungsverfahren nach einem der vorstehenden Ansprüche, wobei die Durchführung mit einer Energie im Bereich von zwischen 100 eV und 600 eV erfolgt.

7. Erzeugungsverfahren nach einem der vorstehenden Ansprüche, wobei die Schutzschicht eine Dicke im Bereich von zwischen 1 Nanometer und 3 Nanometer aufweist.

8. Erzeugungsverfahren nach einem der vorstehenden Ansprüche, wobei der Maskenblock eine kritische Abmessung (dc) im Bereich von zwischen 10 nm und 200 nm aufweist.

9. Erzeugungsverfahren nach einem der vorstehenden Ansprüche, wobei die selektive Prägung mittels HF realisiert wird.

10. Erzeugungsverfahren nach einem der vorstehenden Ansprüche, wobei der Maskenblock (108) in Kontakt mit der ersten Schicht (104) angeordnet ist.

11. Erzeugungsverfahren nach einem der vorstehenden Ansprüche, wobei die Durchführung derart erfolgt, dass sich die dotierten Bereiche (105, 106, 115, 116) in eine Tiefe unter die erste Schicht (104) erstrecken.

12. Erzeugungsverfahren nach einem der vorstehenden Ansprüche, welches mehrere Zyklen mit jedem der Schritte der Bildung der Schutzschicht (110, 120), dem Erzeugungsschritt und dem Prägungs-Schritt der dotierten Bereich (105, 106, 115, 116) der ersten Schicht (104) selektiv in nicht dotierten Bereichen der ersten Schicht (104) und am Maskenblock (108) umfasst.

13. Erzeugungsverfahren nach einem der Ansprüche 1 bis 10, wobei die Durchführung derart erfolgt, dass sich die dotierten Bereiche (105, 106, 115, 116) in eine Tiefe über oder gleich zu der Dicke der ersten Schicht (104) erstrecken, und wobei die Prägung die gesamte Dicke der ersten Schicht (104) betrifft.

14. Erzeugungsverfahren nach einem der vorstehenden Ansprüche, wobei die erste Schicht (104) auf einer zweiten Schicht (100) ruht, wobei das Verfahren weiter nach der selektiven Prägung der dotierten Bereiche (105, 106, 115, 116) der erste Schicht (104) umfasst, eine Prägung der zweiten Schicht durch die erste Schicht (104).

15. Erzeugungsverfahren nach einem der vorstehenden Ansprüche, wobei die Erzeugung mittels eines Plasmas erfolgt und wobei die Bildung der Schutzschicht (110, 120), die Erzeugung und die Prägung in dem gleichen Plasmareaktor durchgeführt wird.

## Claims

1. A method for producing a pattern in a first layer (104) comprising the steps of:
- forming, on a first layer (104), in particular an anti-reflective layer, covered with at least one photo-sensitive resin-based masking block (108) resting on said first layer, a protective layer (110, 120) covering the first layer (104) and said masking block (108),
- implanting areas (105, 106, 115, 116) of the first layer (104) located at the periphery of said masking block (108), using at least one doping species, with the doping species being so selected that the doped areas (105, 106, 115, 116) may be selectively etched relative to the rest of the first layer (104) and relative to the masking block (108), with the implantation, more particularly the energy, duration thereof and the implantation dose, as well as the protective layer (120), more particularly the thickness thereof, being so provided that said doped areas (105, 106, 115, 116) located at the periphery of said masking block and a non-implanted region of the first layer (104) located under the masking block (108) have a boundary directly above or extending from the side face(s) of said masking block,
- etching the doped areas (105, 106, 115, 116) of the first layer (104) selectively with respect to the non-doped areas of the first layer (104) and to the masking block (108).

2. A production method according to claim 1, wherein said first layer (104) is a Si-based layer.

3. A production method according to one of claims 1 or 2, wherein said first layer (104) is an anti-reflective SiARC layer.

4. A production method according to any one of the preceding claims, wherein said implantation is performed using plasma.

5. A production method according to any one of the preceding claims, wherein said doping species is based on hydrogen.

6. A production method according to any one of the preceding claims, wherein the implantation is performed with implantation energy ranging from 100eV to 600eV.

7. A production method according to any one of the preceding claims, wherein said protection layer has a thickness ranging from 1 nanometer to 3 nanometers.

8. A production method according to any one of the preceding claims, wherein said masking block has a critical dimension (cd) ranging from 10nm to 200nm.

9. A production method according to any one of the preceding claims, wherein said selective etching is performed using HF.

10. A production method according to any one of the preceding claims, wherein said masking block (108) is positioned in contact with the first layer (104).

11. A production method according to any one of the preceding claims, wherein the implantation is performed so that the doped areas (105, 106, 115, 116) extend to a depth smaller than the thickness of the first layer (104).

12. A production method according to any one of the preceding claims, comprising a plurality of cycles each comprising said step of forming the protective layer (110, 120), said step of implantation and said step of etching the doped areas (105, 106, 115, 116) of the first layer (104) selectively with respect to non-doped areas of the first layer (104) and to the masking block (108).

13. A production method according to one of claims 1 to 10, wherein said implantation is so performed that the doped areas (105, 106, 115, 116) extend to a depth greater than or equal to the thickness of the first layer (104), and wherein said etching consumes the entire thickness of the first layer (104).

14. A production method according to any one of the preceding claims, wherein the first layer (104) rests on a second layer (100), with the method further comprising, after said selective etching of the doped areas (105, 106, 115, 116) of the first layer (104), the etching of a second layer through the first layer (104).

15. A production method according to any one of the preceding claims, wherein said implantation is performed using plasma, and wherein forming the protective layer (110, 120), said implantation and said etching are performed in the same plasma reactor.
